(19) Europäisches Patentamt

European Patent Office

Office européen des brevets

(11) Publication number: **0 419 771 A2**

## (12) EUROPEAN PATENT APPLICATION

(21) Application number: **90112034.5**

(22) Date of filing: **25.06.90**

(51) Int. Cl.⁵: **H01L 39/24**

(30) Priority: **25.09.89 US 411956**

(43) Date of publication of application:
**03.04.91 Bulletin 91/14**

(84) Designated Contracting States:
**AT BE DE FR GB IT NL**

(71) Applicant: **ROCKWELL INTERNATIONAL CORPORATION**
**2230 East Imperial Highway**
**El Segundo California 90245(US)**

(72) Inventor: **Gay, Richard Leslie**
**10012 Hana Avenue**
**Chatsworth, California 91311(US)**
Inventor: **Grantham, LeRoy Francis**
**26117 Hatmor Drive**
**Calabasa, California 91302(US)**

(74) Representative: **Wächtershäuser, Günter, Dr.**
**Tal 29**
**W-8000 München 2(DE)**

(54) Tailored superconductor ceramics.

(57) A method of tailoring metal oxide ceramic superconductors consisting of mixing a calcined metal oxide powder having a known composition and which is highly reactive with a known amount of a material from the group consisting of metal oxides, metal nitrates, metal hydroxides, metal citrates, metal acetates or metal carbonates and sintering the mixture to form a ceramic superconductor with the desired stoichiometry.

## TAILORED SUPERCONDUCTOR CERAMICS

Field of the Invention

This invention relates to the preparation of highly accurate stoichiometric compounds for superconductors. A highly reactive calcined metal oxide compound may have metal oxides, nitrates or hydroxides axed with it to produce the exact stoichiometry desired in the resultant sintered ceramic superconductor.

Background of the Invention

In copending application serial number 07/268,924 filed 11/09/88 by the same Applicants and assigned to the same company, which is incorporated here by reference, there is disclosed a method for the preparation of metal oxide powders by calcining nitrate solutions of metal oxides.

The preparation of metal oxides as disclosed in the above application sometimes results in a compound which does not have exactly the right proportions of metal oxides.

In that event, the proportions of metal oxides may be adjusted by mixing the desired quantities of metal oxides, nitrates or hydroxides with the highly reactive calcined metal oxide powder and then sintering the mixture to form a well-mixed superconductive ceramic.

Description of the Preferred Embodiment

When making metal oxide powders by the process of calcining metal nitrate solutions as disclosed in application 07/268,924, the calcined powder may have a stoichiometry which is different than what was desired. This may be caused by use of a metal nitrate solution which had the wrong proportion of metal nitrates, by the wrong temperature being used during calcining, by calcining for the wrong period of time or for other reasons.

It may also be the case that the metal oxide powder is of the correct stoichiometry when calcined but a different mixture is desired to be studied or tested.

In either case, when a calcined metal oxide powder has a different composition of compounds than is desired in the final sintered superconducting metal oxide ceramic, it is possible to alter the composition of the compound.

The calcined metal oxide powder obtained by the process as disclosed in patent application serial number 07/268,924 is a highly reactive powder.

To alter the stoichiometry of the compound a metal oxide, nitrate or hydroxide may be added to the calcined metal oxide powder and mixed with standard grinding techniques with a mortar and pestle, or by other methods.

The calcined metal oxide powder should be analyzed to determine the weights of the components of the compound and then weigh out the material to be added so that the final product will have the correct ratio by weight of components to make the desired compound.

The mixed calcined metal oxide powder and metal oxide, nitrate or hydroxide is then sintered to form a ceramic superconductor of the desired stolchiometry.

It should be noted that other compounds that decompose on heating such as citrates, acetates or some carbonates may also be mixed with the calcined metal oxide powder.

Since the calcined metal oxide powder is highly reactive it readily incorporates the new metal ions into the desired superconductor crystal structure when sintered.

In general, the added metal oxides or other compounds are limited to an amount equal to the starting calcined metal oxide powder by weight.

In addition to yielding the new desired stolchiometry and incorporating the new powder into the metal oxide matrix, the final product has a higher density and hardness and superior superconducting properties from calcined nitrate-solution than from mixtures made by grinding oxide powders together that have not been calcined.

As an example of practicing the invention, a mixture of calcined oxides having the composition given in Table 1 was tailored to give a desired final composition, also given in Table 1.

# EP 0 419 771 A2

Table 1.

| Mixture Compositions | | | | |
|---|---|---|---|---|
| | Tl | Ba | Ca | Cu |
| Initial calcined mixture, moles | 0.32 | 1.00 | 1.43 | 0.35 |
| Desired final product, moles | 1.00 | 1.00 | 1.43 | 1.50 |

Tailoring was accomplished by adding the oxide powders (not calcined) in the proportions given in Table 2.

Table 2.

| Required Oxide Addition | |
|---|---|
| Material | Required Addition, Grams/Gram of Initial Calcined Mixture |
| $Tl_2O_3$ | 0.464 |
| BaO | 0.000 |
| CaO | 0.000 |
| CuO | 0.273 |

The oxide powders were mixed with the calcined powder by grinding them together by hand in a jade mortar and pestle. The total mixture had a mass of 3.48 grams. The material was cold pressed in a hand press at approximately 38,000 psi into a pellet with the weight and dimensions given in Table 3.

The pellet was sintered in oxygen for 1 hour at 470°C, 18 minutes at 890°C, and 4 hours at 865°C, then allowed to cool to room temperature for about 2 hours. The weight and dimensions of the pellet after sintering are also given in Table 3.

Table 3.

| Weight and Dimensions of Tailored Pellet | | | |
|---|---|---|---|
| | Weight, grams | Diameter, cm | Thickness, cm |
| Initial pellet | 1.3107 | 1.28 | 0.272 |
| After sintering | 0.9339 | 1.25 | 0.267 |

The pellet was examined by X-ray diffraction. The diffraction pattern showed a significant number of peaks distinctive of the 2223 superconductor crystal, $Tl_2Ba_2Ca_2Cu_3O_x$, and small amount of peaks of the 2312 superconductor crystal, $Tl_2Ba_2CaCu_2O_x$.

An additional pellet was prepared using the initial calcined mixture described in Table 1. No oxides were added to this pellet. The pellet was hand-pressed and sintered in oxygen according to the same time and temperature conditions described above. The weight and dimensions of the initial and final pellet without tailoring are given in Table 4.

3

Table 4.

| Weight and Dimensions of Tailored Pellet Without Tailoring | | | |
|---|---|---|---|
| | Weight, grams | Diameter, cm | Thickness, cm |
| Initial pellet | 1.3109 | 1.28 | 0.341 |
| After sintering | 1.0931 | 1.30 | 0.368 |

An X-ray diffraction pattern was measured for the sintered pellet without tailoring. No superconductor crystal peaks were found.

**Claims**

1. A process for tailoring superconductor ceramics which comprises:
analyzing a calcined metal oxide compound to determine its composition,
mixing a known amount of at least one of the materials chosen from a group consisting of metal oxides, metal nitrates, metal hydroxides, metal citrates, metal acetates and metal carbonates which decompose on heating to form metal oxides, with the calcined metal oxide compound and sintering the mixture to form a stoichiometrically desired ceramic superconductor.

2. A process for tailoring superconductor ceramics as in claim 1 where the mixture is sintered in oxygen.

3. A process for tailoring superconductor ceramics as in claim 1 where the mixture is formed into pellets before sintering.

4. A process for tailoring superconductor ceramics as in claim 1 where the added material is limited to an equal amount by weight of the calcined metal oxide compound.

5. A process for tailoring superconductor ceramics as in claim 1 where $Tl_2 Ba_2 Ca_2 Cu_3 O_x$ is produced by analyzing the calcined metal oxide compound to determine the quantities of Tl, Ba, Ca and Cu oxides in the compound, mixing the compound with known quantities of $Tl_2O_3$, BaO, CaO and CuO to form $Tl_2$, $Ba_2$, $Ca_2$, $Cu_3 O_x$ when sintered,
compressing the, mixture into pellets
sintering the pellets in oxygen, first at $470°$ C for 1 hour, then at $890°$ C for 18 minutes and then at $865°$ for 4 hours.

6. A process for tailoring superconductor ceramics as in claim 5 where the added material is limited to an equal amount in weight of the calcined metal oxide compound.

7. A process of tailoring superconductor ceramics as in claim 2 where the mixture is formed into pellets before sintering.

8. A process for tailoring superconductor ceramics as in claim 7 where the added material is limited to an equal amount by weight of the calcined metal oxide compound.